# EUROPÄISCHE PATENTSCHRIFT

(11) **EP 2 272 111 B1**
(45) Veröffentlichungstag und Bekanntmachung des Hinweises auf die Patenterteilung: **28.01.2015**
(21) Anmeldenummer: 09738091.9
(22) Anmeldetag: 27.04.2009
(51) Int. Cl.: H01L 37/04

(54) **THERMOMAGNETISCHER GENERATOR**
THERMOMAGNETIC GENERATOR
GÉNÉRATEUR THERMOMAGNÉTIQUE

(30) Priorität: 28.04.2008 EP 08155253
(43) Veröffentlichungstag der Anmeldung: 12.01.2011
(73) Patentinhaber: Technology Foundation - STW, 3527 JP Utrecht (NL); Technische Universiteit Delft, 2628 CN Delft (NL)
(72) Erfinder: REESINK, Bennie, NL-7107 AD Winterswijk-Koten (NL); DEGEN, Georg, 64653 Lorsch (DE); BRÜCK, Ekkehard, 2628 AH Delft (NL)
(74) Vertreter: Féaux de Lacroix, Stefan
(86) Internationale Anmeldenummer: PCT/EP2009/055022
(87) Internationale Veröffentlichungsnummer: WO 2009/133047

(56) Entgegenhaltungen:
- WO-A-00/64038
- WO-A-2004/068512
- DE-A1-102006 015 370
- FR-A- 2 890 158
- US-A1- 2005 062 360

## Beschreibung

Die Erfindung betrifft einen thermomagnetischen Generator, der Wärmeenergie in elektrische Energie umwandelt ohne zwischenzeitliche Umwandlung in mechanische Arbeit.

Die in thermomagnetischen Generatoren eingesetzten Materialien basieren auf dem magnetokalorischen Effekt (MCE). In einem Material, das einen magnetokalorischen Effekt zeigt, führt die Ausrichtung von zufällig orientierten magnetischen Momenten durch ein externes Magnetfeld zu einem Erwärmen des Materials. Diese Wärme kann vom MCE-Material in die Umgebungsatmosphäre durch einen Wärmetransfer abgeführt werden. Wenn das Magnetfeld daraufhin abgestellt oder entfernt wird, gehen die magnetischen Momente wieder in eine Zufallsanordnung über, was zu einem Abkühlen des Materials unter Umgebungstemperatur führt. Dieser Effekt kann einerseits zu Kühlzwecken ausgenutzt werden, andererseits, um Wärme in elektrische Energie umzuwandeln.

Die magnetokalorische Erzeugung von elektrischer Energie ist verbunden mit der magnetischen Heizung und Kühlung. In den Zeiten der ersten Konzipierung wurde das Verfahren zur Energieerzeugung als pyromagnetische Energieerzeugung beschrieben. Verglichen mit Vorrichtungen der Peltier- oder Seebeck-Typs können diese magnetokalorischen Vorrichtungen eine wesentlich höhere Energieeffizienz aufweisen.

Die Forschung zu diesem physikalischen Phänomen begann im späten 19. Jahrhundert, als zwei Wissenschaftler, Tesla und Edison, pyromagnetische Generatoren zum Patent anmeldeten. Im Jahr 1984 beschrieb Kirol zahlreiche mögliche Anwendungen und führte thermodynamische Analysen davon durch. Damals wurde Gadolinium als ein potentielles Material für Anwendungen nahe Raumtemperatur angesehen.

Ein pyromagneto-elektrischer Generator ist beispielsweise von N. Tesla in US 428,057 beschrieben. Es ist angegeben, dass die magnetischen Eigenschaften von Eisen oder anderen magnetischen Substanzen teilweise oder ganz zerstört werden können oder verschwinden können durch Erhitzen auf eine bestimmte Temperatur. Beim Abkühlen werden die magnetischen Eigenschaften wiederhergestellt und kehren in den Ausgangszustand zurück. Dieser Effekt kann ausgenutzt werden, um elektrischen Strom zu erzeugen. Wird ein elektrischer Leiter einem variierenden Magnetfeld ausgesetzt, führen die Veränderungen des Magnetfelds zur Induzierung eines elektrischen Stroms im Leiter. Wird beispielsweise das magnetische Material von einer Spule umschlossen und sodann in einem permanenten Magnetfeld erhitzt und nachfolgend abgekühlt, so wird jeweils beim Aufwärmen und Abkühlen ein elektrischer Strom in der Spule induziert. Hierdurch kann Wärmeenergie in elektrische Energie umgewandelt werden, ohne dass zwischenzeitlich eine Umwandlung in mechanischer Arbeit erfolgt. In dem von Tesla beschriebenen Verfahren wird Eisen als magnetische Substanz über einen Ofen oder eine geschlossene Feuerstelle erhitzt und nachfolgend wieder abgekühlt.

T. A. Edison beschreibt in US 476,983 ebenfalls einen pyromagnetischen Generator, in dem wiederum Eisen als thermomagnetisches Material eingesetzt wird. Das Eisen wird in Form von Röhren mit kleinem Durchmesser eingesetzt, die zu Röhrbündeln zusammengefasst sind. Jedes Rohr ist dabei so dünn wie möglich ausgearbeitet, so dass es schnell erhitzt und abgekühlt werden kann. Das Eisen wird gegen die Oxidation durch eine Nickelplattierung oder Emaillierung geschützt. Die Rohrbündel sind auf einer kreisförmigen Scheibe angeordnet und werden nacheinander erhitzt bzw. abgekühlt, während an ihnen ein Magnetfeld anliegt. Das Erhitzen wird wiederum durch eine Feuerung erreicht, wobei die für die Feuerung erforderliche Frischluft durch die Rohre geführt werden kann, die abgekühlt werden sollen.

L. D. Kirol und J. I. Mills beschreiben theoretische Berechnungen zu thermomagnetischen Generatoren. Dabei wird von Magnetfeldern ausgegangen, die durch einen supraleitenden Magneten erreicht werden. Als Materialien werden Eisen, Gadolinium und Ho₆₉Fe₁₃ betrachtet neben einem hypothetischen Material. Die betrachteten Materialien haben entweder sehr niedrige Curie-Temperaturen oder sehr hohe Curie-Temperaturen, während kein Material für die gewünschte Arbeit bei Umgebungstemperatur beschrieben ist.

US 2005/0062360 betrifft einen thermischen Motor und einen thermischen Energieerzeuger unter Verwendung eines magnetischen Körpers. Es wird ein magnetischer Körper vorgeschlagen, der eine große Magnetisierungsdifferenz aufweist und damit einen hohen mechanischen oder elektrischen Energieaustrag erlaubt. Als geeignete Materialien werden MnAs, Mn(As_{0,95}Sb_{0,05}), MnFe(P_{0,45}S_{0,55}), La(Fe_{0,88}Si_{0,12})₁₃H₁₅ sowie La(Fe₁₋ₓSiₓ)₁₃H_{y} mit 0 ≤ y ≤ 3 und 0,2 ≤ x ≤ 0,8 genannt.

WO 2004068512 betrifft ein magnetisches Material mit Kühlwirkung, ein Verfahren zur Herstellung und die Verwendung des Materials. Als Materialien werden insbesondere FeMnP_{0,7}Ge_{0,3}, FeMnP_{0,5}Ge_{0,5}, FeMnP_{0,5}Ge_{0,1}Si_{0,4}, Fe_{0,86}Mn_{1,14}P_{0,5}Si_{0,35}Ge_{0,15} beschrieben.

Aufgabe der vorliegenden Erfindung ist die Bereitstellung eines thermoelektrischen Generators, der Wärmeenergie in elektrische Energie umwandelt ohne zwischenzeitliche Umwandlung in mechanische Arbeit, der bei Temperaturen in der Nähe von Raumtemperatur mit hohen Energieausbeuten arbeitet. Damit soll es möglich sein, bei und um Raumtemperatur herum einen magnetokalorischen Effekt für die Erzeugung von Strom aus Abwärme ausnutzen zu können.

So soll es möglich werden, aus Abwasser bzw. der Abwärme aus industriellen Prozessen oder aus Solarenergie oder Sonnenkollektoren Strom zu gewinnen.

Die Aufgabe wird erfindungsgemäß gelöst durch einen thermoelektrischen Generator, der Wärmeenergie in elektrische Energie umwandelt ohne zwischenzeitliche Umwandlung in mechanische Arbeit, der bei Temperaturen im Bereich von -20 °C bis 200 °C arbeitet und eine Serie von mindestens 3 unterschiedlichen metallbasierten thermomagnetischen Materialien enthält, deren magnetokalorischer Effekt bei unterschiedlichen Temperaturen auftritt, so dass die Umwandlung der Wärmeenergie in elektrische Energie eine vergrößerte Temperaturspanne ausnutzen kann, ausgewählt aus (1) Verbindungen der allgemeinen Formel (I)

(A_{y}B_{1-y})_{2+δ}C_{w}DₓE_{z} (I)

mit der Bedeutung
- A: Mn oder Co,
- B: Fe, Cr oder Ni,
- C, D, E: mindestens zwei von C, D, E sind voneinander verschieden, haben eine nicht-verschwindende Konzentration und sind ausgewählt aus P, B, Se, Ge, Ga, Si, Sn, N, As und Sb, wobei mindestens eines von C, D und E Ge oder Si ist,
- δ: Zahl im Bereich von - 0,1 bis 0,1
- w, x, y, z: Zahlen im Bereich von 0 bis 1, wobei w + x + z = 1 ist;

(2) auf La und Fe basierenden Verbindungen der allgemeinen Formeln (II) und/oder (III) und/oder (IV)

   La(FeₓAl₁₋ₓ)₁₃H_{y} oder La(FeₓSi₁₋ₓ)₁₃H_{y} (II)

   mit
   - x: Zahl von 0,7 bis 0,95
   - y: Zahl von 0 bis 3, vorzugsweise 0 bis 2;

   La(FeₓAl_{y}Co_{z})₁₃ oder La(FeₓSiyCo_{z})₁₃ (III)

   mit
   - x: Zahl von 0,7 bis 0,95
   - y: Zahl von 0,05 bis 1 - x
   - z: Zahl von 0,005 bis 0,5;

   LaMnₓFe₂₋ₓGe (IV)

   mit
   - x: Zahl von 1,7 bis 1,95 und
(3) Heusler-Legierungen des Typs MnTP mt T Übergangsmetall und P einem p-dotierenden Metall mit einem electron count pro Atom e/a im Bereich von 7 bis 8,5.
(4) auf Gd und Si basierenden Verbindungen der allgemeinen Formel (V)

   Gd₅(SiₓGe₁₋ₓ)₄ (V)

   mit x Zahl von 0,2 bis 1,
(5) Fe₂P-basierten Verbindungen,
(6) Manganiten des Perovskit-Typs,
(7) Seltenerden-Elemente enthaltenden Verbindungen der allgemeinen Formeln (VI) und (VII)

   Tb₅(Si₄₋ₓGeₓ) (VI)

   mit x = 0, 1, 2, 3, 4

   XTiGe (VII)

   mit X = Dy, Ho, Tm,
(8) auf Mn und Sb oder As basierenden Verbindungen der allgemeinen Formeln (VIII) und (IX)

   Mn₂₋ₓZₓSb (VIII)

   Mn₂ZₓSb₁₋ₓ (IX)

   mit
   - Z: Cr, Cu, Zn, Co, V, As, Ge,
   - x: 0,01 bis 0,5,
   wobei Sb durch As ersetzt sein kann, sofern Z nicht As ist.

Es wurde erfindungsgemäß gefunden, dass die vorstehenden thermomagnetischen Materialien vorteilhaft in thermomagnetischen Generatoren eingesetzt werden können, um die Umwandlung von (Ab)wärme in elektrischen Strom im Umfeld der Raumtemperatur, das heißt bei Temperaturen im Bereich von -20 bis 200 °C, zu ermöglichen. Die Energieumwandlung erfolgt dabei bevorzugt bei Temperaturen im Bereich von 20 bis 150 °C, insbesondere bei Temperaturen im Bereich von 40 bis 120 °C.

Die erfindungsgemäß eingesetzten Materialien sind prinzipiell bekannt und zum Teil beispielsweise in WO 2004/068512 beschrieben.

Dabei ist das metallbasierte Material ausgewählt aus den vorstehenden Materialien (1) bis (8).

Besonders bevorzugt sind erfindungsgemäß die metallbasierten Materialien ausgewählt aus den Verbindungen (1), (2) und (3) sowie (5).

Erfindungsgemäß besonders geeignete Materialien sind beispielsweise in WO 2004/068512, Rare Metals, Vol. 25, 2006, Seiten 544 bis 549, J. Appl. Phys. 99,08Q107 (2006), Nature, Vol. 415, 10. Januar 2002, Seiten 150 bis 152 und Physica B 327 (2003), Seiten 431 bis 437 beschrieben.

In den vorstehend genannten Verbindungen der allgemeinen Formel (I) sind bevorzugt C, D und E identisch oder unterschiedlich und ausgewählt aus mindestens einem von P, Ge, Si, Sn und Ga.

Das metallbasierte Material der allgemeinen Formel (I) ist vorzugsweise ausgewählt aus mindestens quarternären Verbindungen, die neben Mn, Fe, P und gegebenenfalls Sb zudem Ge oder Si oder As oder Ge und Si, Ge und As oder Si und As oder Ge, Si und As enthalten.

Bevorzugt sind mindestens 90 Gew.-%, besonders bevorzugt mindestens 95 Gew.-% der Komponente A Mn. Bevorzugt sind mindestens 90 Gew.-%, besonders bevorzugt mindestens 95 Gew.-% von B Fe. Bevorzugt sind mindestens 90 Gew.-%, besonders bevorzugt mindestens 95 Gew.-% von C P. Bevorzugt sind mindestens 90 Gew.-%, besonders bevorzugt mindestens 95 Gew.-% von D Ge. Bevorzugt sind mindestens 90 Gew.-%, besonders bevorzugt mindestens 95 Gew.-% von E Si.

Vorzugsweise hat das Material die allgemeine Formel MnFe(P_{w}GeₓSi_{z}). Bevorzugt ist x eine Zahl im Bereich von 0,3 bis 0,7, w ist kleiner oder gleich 1-x und z entspricht 1-x-w.

Das Material hat vorzugsweise die kristalline hexagonale Fe₂P-Struktur. Beispiele geeigneter Strukturen sind MnFeP_{0,45} bis _{0,7}, Ge_{0,55} bis _{0,30} und MnFeP_{0,5} bis _{0,70}, (Si/Ge)_{0,5 bis 0,30-}

Geeignete Verbindungen sind ferner Mₙ₁₊ₓFe₁₋ₓP_{1-y}Ge_{y} mit x im Bereich von -0,3 bis 0,5, y im Bereich von 0,1 bis 0,6. Ebenfalls geeignet sind Verbindungen der allgemeinen Formel Mn₁₊ₓFe₁₋ₓP_{1-y}Ge_{y-z}Sb_{z} mit x im Bereich von -0,3 bis 0,5, y im Bereich von 0,1 bis 0,6 und z kleiner als y und kleiner als 0,2. Ferner sind Verbindungen der Formel Mn₁₊ₓFe₁₋ₓP_{1-y}Ge_{y-z}Si_{z} geeignet mit x Zahl im Bereich von 0,3 bis 0,5, y im Bereich von 0,1 bis 0,66, z kleiner oder gleich y und kleiner als 0,6.

Geeignet sind ferner weitere Fe₂P-basierte Verbindungen ausgehend von Fe₂P und FeAs₂, gegebenenfalls Mn und P. Sie entsprechen beispielsweise den allgemeinen Formeln MnFe₁₋ₓCoₓGe, mit x = 0,7 - 0,9, Mn₅₋ₓFeₓSi₃ mit x = 0 - 5, Mn₅Ge₃₋ₓSiₓ mit x = 0,1 - 2, Mn₅Ge₃₋ₓSbₓ mit x = 0 - 0,3, Mn₂₋ₓFeₓGe₂ mit x = 0,1 - 0,2, (Fe_{1_x}Mnₓ)₃C mit x = ...-..., Mn₃₋ₓCoₓGaC mit x = 0 - 0,05.

Bevorzugte auf La und Fe basierende Verbindungen der allgemeinen Formeln (II) und/oder (III) und/oder (IV) sind La(Fe_{0,90}Si₀,₁₀)₁₃, La(Fe_{0,89}Si_{0,11})₁₃, La(Fe_{0,880}Si_{0,120})₁₃, La(Fe_{0,877}Si_{0,123})₁₃, L a F e_{11,8}Si_{1,2}, La(Fe_{0,88}Si_{0,12})₁₃H_{0,5}, La(Fe_{0,88}Si_{0,12})₁₃H_{1,0}, LaFe_{11,7}Si_{1,3}H_{1,1}, L a F e_{11,57}Si_{1,43}H_{1,3}, La(Fe_{0,88}Si_{0,12})H_{1,5}, LaFe_{11,2}Co_{0,7}Si_{1,1}, LaFe_{11,5}Al_{1,5}C_{0,1}, LaFe_{11,5}Al_{1,5}C_{0,2}, LaFe_{11,5}Al_{1,5}C_{0,4}, LaFe_{11,5}Al_{1,5}Co_{0,5}, La(Fe_{0,94}Co_{0,06})_{11,83}Al_{1,17}, La(Fe_{0,92}Co_{0,08})_{11,83}Al_{1,17}.

Geeignete Mangan enthaltende Verbindungen sind MnFeGe, MnFe_{0,9}Co_{0,1}Ge, MnFe_{0,8}Co_{0,2}Ge, MnFe_{0,7}Co_{0,3}Ge, MnFe_{0,6}Co_{0,4}Ge, MnFe_{0,5}Co_{0,5}Ge, MnFe_{0,4}Co_{0,6}Ge, MnFe_{0,3}Co_{0,7}Ge, MnFe_{0,2}Co_{0,8}Ge, MnFe_{0,15}Co_{0,85}Ge, MnFe_{0,1}Co_{0,9}Ge, MnCoGe, Mn₅Ge_{2,5}Si_{0,5}, Mn₅Ge₂Si, Mn₅Ge_{1,5}Si_{1,5}, Mn₅GeSi₂, Mn₅Ge₃, Mn₅Ge_{2,9}Sb_{0,1}, Mn₅Ge_{2,8}Sb_{0,2}, Mn₅Ge_{2,7}Sb_{0,3}, LaMn_{1,9}Fe_{0,1}Ge, LaMn_{1,85}Fe_{0,15}Ge, LaMn_{1,8}Fe_{0,2}Ge, (Fe_{0,9}Mn_{0,1})₃C, (Fe_{0,8}Mn_{0,2})₃C, ( F e_{0,7}Mn_{0,3})₃C, Mn₃GaC, MnAs, (Mn, Fe)As, Mn_{1+δ}As_{0,8}Sb_{0,2}, MnAs_{0,75}Sb_{0,25}, Mn_{1,1}As_{0,75}Sb_{0,25}, Mn_{1,5}As_{0,75}Sb_{0,25}.

Erfindungsgemäß geeignete Heusler-Legierungen sind beispielsweise Ni₂MnGa, Fe₂MnSi₁₋ₓGeₓ mit x = 0 - 1 wie Fe₂MnSi_{0,5}Ge_{0,5}, Ni_{52,9}Mn_{22,4}Ga_{24,7}, Ni_{50,9}Mn_{24,7}Ga_{24,4}, Ni_{55,2}Mn_{18,6}Ga_{26,2}, Ni_{51,6}Mn_{24,7}Ga_{23,8}, Ni_{52,7}Mn_{23,9}Ga_{23,4}, CoMnSb, CoNb_{0,2}Mn_{0,8}Sb, CoNb_{0,4}Mn_{0,6}SB, CoNb_{0,6}Mn_{0,4}Sb, Ni₅₀Mn₃₅Sn₁₅, Ni₅₀Mn₃₇Sn₁₃, MnFeP_{0,45}As_{0,55}, MnFeP_{0,47}As_{0,53}, Mn_{1,1}Fe_{0,9}P_{0,47}As_{0,53}, MnFeP_{0,89-χ}Si_{χ}Ge_{0,11}, x= 0,22, χ = 0,26, χ = 0,30, χ = 0,33.

Weiterhin geeignet sind Fe₉₀Zr₁₀, Fe₈₂Mn₈Zr₁₀, Co₆₆Nb₉Cu₁Si₁₂B₁₂, Pd₄₀Ni_{22,5}Fe_{17,5}P₂₀, FeMoSiBCuNb, Gd₇₀Fe₃₀, GdNiAl, NdFe₁₂B₆GdMn₂.

Manganite des Perovskit-Typs sind beispielsweise La_{0,6}Ca_{0,4}MnO₃, La_{0,67}Ca_{0,33}MnO₃, La_{0,8}Ca_{0,2}MnO₃, La_{0,7}Ca_{0,3}MnO₃, La_{0,958}Li_{0,025}Ti_{0,1}Mn_{0,9}O₃, La_{0,65}Ca_{0,35}Ti_{0,1}Mn_{0,9}O₃, La_{0,799}Na_{0,199}MnO_{2,97}, La_{0,88}Na_{0,099}Mn_{0,977}O₃, La_{0,877}K_{0,096}Mn_{0,974}O₃, La_{0,65}Sr_{0,35}Mn_{0,95}Cn_{0,05}O₃, La_{0,7}Nd_{o0,1}Na_{0,2}MnO₃, La_{0,5}Ca_{0,3}Sr_{0,2}MnO₃.

Auf Gd und Si basierende Verbindungen der allgemeinen Formel (V)

Gd₅(SiₓGe₁₋ₓ)₄

mit x Zahl von 0,2 bis 1
sind beispielsweise Gd₅(Si_{0,5}Ge_{0,5})₄, Gd₅(Si_{0,425}Ge_{0,575})₄, Gd₅(Si_{0,45}Ge_{0,55})₄, Gd₅(Si_{0,365}Ge_{0,635})₄, Gd₅(Si_{0,3}Ge_{0,7})₄, Gd₅(Si_{0,25}Ge_{0,75})₄.

Seltenerden-Elemente enthaltende Verbindungen sind Tb₅(Si₄₋ₓGeₓ) mit x = 0, 1, 2, 3, 4 oder XTiGe mit X = Dy, Ho, Tm, beispielsweise Tb₅Si₄, Tb₅(Si₃Ge), Tb(Si₂Ge₂), Tb₅Ge₄, DyTiGe, HoTiGe, TmTiGe.

Auf Mn und Sb oder As basierende Verbindungen der allgemeinen Formeln (VIII) und (IX) haben bevorzugt die Bedeutungen z = 0,05 bis 0,3, Z = Cr, Cn, Ge, As, Co.

Die erfindungsgemäß eingesetzten thermomagnetischen Materialien können in beliebiger geeigneter Weise hergestellt werden.

Die Herstellung der thermomagnetischen Materialien erfolgt beispielsweise durch Festphasenumsetzung der Ausgangselemente oder Ausgangslegierungen für das Material in einer Kugelmühle, nachfolgendes Verpressen, Sintern und Tempern unter Inertgasatmosphäre und nachfolgendes langsames Abkühlen auf Raumtemperatur. Ein derartiges Verfahren ist beispielsweise in J. Appl. Phys. 99, 2006, 08Q107 beschrieben.

Auch eine Verarbeitung über das Schmelzspinnen ist möglich. Hierdurch ist eine homogenere Elementverteilung möglich, die zu einem verbesserten magnetokalorischen Effekt führt, vergleiche Rare Metals, Vol. 25, Oktober 2006, Seiten 544 bis 549. In dem dort beschriebenen Verfahren werden zunächst die Ausgangselemente in einer Argongas-atmosphäre induktionsgeschmolzen und sodann in geschmolzenem Zustand über eine Düse auf eine sich drehende Kupferwalze gesprüht. Es folgt ein Sintern bei 1000 °C und ein langsames Abkühlen auf Raumtemperatur.

Ferner kann für die Herstellung auf WO 2004/068512 verwiesen werden.

Die nach diesen Verfahren erhaltenen Materialien zeigen häufig eine große thermische Hysterese. Beispielsweise werden in Verbindungen des Fe₂P-Typs, die mit Germanium oder Silicium substituiert sind, große Werte für die thermische Hysterese in einem großen Bereich von 10 K oder mehr beobachtet.

Bevorzugt ist daher ein Verfahren zur Herstellung von thermomagnetischen Materialien für die magnetische Kühlung, umfassend die folgenden Schritte:
a) Umsetzung von chemischen Elementen und/oder Legierungen in einer Stöchiometrie, die dem metallbasierten Material entspricht, in der Fest- und/oder Flüssigphase,
b) gegebenenfalls Überführen des Umsetzungsproduktes aus Stufe a) in einen Festkörper,
c) Sintern und/oder Tempern des Festkörpers aus Stufe a) oder b),
d) Abschrecken des gesinterten und/oder getemperten Festkörpers aus Stufe c) mit einer Abkühlgeschwindigkeit von mindestens 100 K/s.

Die thermische Hysterese kann signifikant vermindert werden und ein großer magnetokalrischer Effekt kann erreicht werden, wenn die metallbasierten Materialien nach dem Sintern und/oder Tempern nicht langsam auf Umgebungstemperatur abgekühlt werden, sondern mit einer hohen Abkühlgeschwindigkeit abgeschreckt werden. Dabei beträgt die Abkühlgeschwindigkeit mindestens 100 K/s. Bevorzugt beträgt die Abkühlgeschwindigkeit 100 bis 10000 K/s, besonders bevorzugt 200 bis 1300 K/s. Speziell bevorzugt sind Abkühlgeschwindigkeiten von 300 bis 1000 K/s.

Das Abschrecken kann dabei durch beliebige geeignete Kühlverfahren erreicht werden, beispielsweise durch Abschrecken des Festkörpers mit Wasser oder wasserhaltigen Flüssigkeiten, beispielsweise gekühltem Wasser oder Eis/Wasser-Mischungen. Die Festkörper können beispielsweise in eisgekühltes Wasser fallengelassen werden. Es ist ferner möglich, die Festkörper mit untergekühlten Gasen wie flüssigem Stickstoff abzuschrecken. Weitere Verfahren zum Abschrecken sind dem Fachmann bekannt. Vorteilhaft ist dabei ein kontrolliertes und schnelles Abkühlen.

Die übrige Herstellung der thermomagnetischen Materialien ist weniger kritisch, solange im letzten Schritt das Abschrecken des gesinterten und/oder getemperten Festkörpers mit der erfindungsgemäßen Abkühlgeschwindigkeit erfolgt. Das Verfahren kann dabei auf die Herstellung beliebiger geeigneter thermomagnetischer Materialien für die magnetische Kühlung angewendet werden, wie sie vorstehend beschreiben sind.

In Schritt (a) des Verfahrens erfolgt die Umsetzung der Elemente und/oder Legierungen, die im späteren thermomagnetischen Material enthalten sind, in einer Stöchiometrie, die dem thermomagnetischen Material entspricht, in der Fest- oder Flüssigphase.

Vorzugsweise wird die Umsetzung in Stufe a) durch gemeinsames Erhitzen der Elemente und/oder Legierungen in einem geschlossenen Behältnis oder in einem Extruder, oder durch Festphasenumsetzung in einer Kugelmühle erfolgen. Besonders bevorzugt wird eine Festphasenumsetzung durchgeführt, die insbesondere in einer Kugelmühle erfolgt. Eine derartige Umsetzung ist prinzipiell bekannt, vergleiche die vorstehend aufgeführten Schriften. Dabei werden typischerweise Pulver der einzelnen Elemente oder Pulver von Legierungen aus zwei oder mehr der einzelnen Elemente, die im späteren thermomagnetischen Material vorliegen, in geeigneten Gewichtsanteilen pulverförmig vermischt. Falls notwendig, kann zusätzlich ein Mahlen des Gemisches erfolgen, um ein mikrokristallines Pulvergemisch zu erhalten. Dieses Pulvergemisch wird vorzugsweise in einer Kugelmühle aufgeheizt, was zu einer weiteren Verkleinerung wie auch guten Durchmischung und zu einer Festphasenreaktion im Pulvergemisch führt. Alternativ werden die einzelnen Elemente in der gewählten Stöchiometrie als Pulver vermischt und anschließend aufgeschmolzen.

Das gemeinsame Erhitzen in einem geschlossenen Behälter erlaubt die Fixierung flüchtiger Elemente und die Kontrolle der Stöchiometrie. Gerade bei Mitverwendung von Phosphor würde dieser in einem offenen System leicht verdampfen.

An die Umsetzung schließt sich ein Sintern und/oder Tempern des Festkörpers an, wobei ein oder mehrere Zwischenschritte vorgesehen sein können. Beispielsweise kann der in Stufe a) erhaltene Feststoff verpresst werden, bevor er gesintert und/oder getempert wird. Hierdurch wird die Dichte des Materials erhöht, so dass bei der späteren Anwendung eine hohe Dichte des thermomagnetischen Materials vorliegt. Dies ist insbesondere deshalb vorteilhaft, da das Volumen, in dem das magnetische Feld herrscht, vermindert werden kann, was mit erheblichen Kosteneinsparungen verbunden sein kann. Das Verpressen ist an sich bekannt und kann mit oder ohne Presshilfsmittel durchgeführt werden. Dabei kann jede beliebige geeignete Form zum Pressen verwendet werden. Durch das Verpressen ist es bereits möglich, Formkörper in der gewünschten dreidimensionalen Struktur zu erzeugen. An das Verpressen kann sich das Sintern und/oder Tempern der Stufe c) gefolgt vom Abschrecken der Stufe d) anschließen.

Alternativ ist es möglich, den aus der Kugelmühle erhaltenen Feststoff einem Schmelzspinnverfahren zuzuführen. Schmelzspinnverfahren sind an sich bekannt und beispielsweise in Rare Metals, Vol. 25, Oktober 2006, Seiten 544 bis 549 wie auch in WO 2004/068512 beschrieben.

Dabei wird die in Stufe a) erhaltene Zusammensetzung geschmolzen und auf eine sich drehende kalte Metallwalze gesprüht. Dieses Sprühen kann mittels Überdruck vor der Sprühdüse oder Unterdruck hinter der Sprühdüse erreicht werden. Typischerweise wird eine sich drehende Kupfertrommel oder -walze verwendet, die zudem gegebenenfalls gekühlt werden kann. Die Kupfertrommel dreht sich bevorzugt mit einer Oberflächengeschwindigkeit von 10 bis 40 m/s, insbesondere 20 bis 30 m/s. Auf der Kupfertrommel wird die flüssige Zusammensetzung mit einer Geschwindigkeit von vorzugsweise 10² bis 10⁷ K/s abgekühlt, besonders bevorzugt mit einer Geschwindigkeit von mindestens 10⁴ K/s, insbesondere mit einer Geschwindigkeit von 0,5 bis 2 x 10⁶ K/s.

Das Schmelzspinnen kann wie auch die Umsetzung in Stufe a) unter vermindertem Druck oder unter Inertgasatmosphäre durchgeführt werden.

Durch das Meltspinning wird eine hohe Verarbeitungsgeschwindigkeit erreicht, da das nachfolgende Sintern und Tempern verkürzt werden kann. Gerade im technischen Maßstab wird so die Herstellung der thermomagnetischen Materialien wesentlich wirtschaftlicher. Auch die Sprühtrocknung führt zu einer hohen Verarbeitungsgeschwindigkeit. Besonders bevorzugt wird das Schmelzespinnen (Melt spinning) durchgeführt.

Alternativ kann in Stufe b) ein Sprühkühlen durchgeführt werden, bei dem eine Schmelze der Zusammensetzung aus Stufe a) in einen Sprühturm gesprüht wird. Der Sprühturm kann dabei beispielsweise zusätzlich gekühlt werden. In Sprühtürmen werden häufig Abkühlgeschwindigkeiten im Bereich von 10³ bis 10⁵ K/s, insbesondere etwa 10⁴ K/s erreicht.

Das Sintern und/oder Tempern des Festkörpers erfolgt in Stufe c) vorzugsweise zunächst bei einer Temperatur im Bereich von 800 bis 1400 °C zum Sintern und nachfolgend bei einer Temperatur im Bereich von 500 bis 750 °C zum Tempern. Diese Werte gelten insbesondere für Formkörper, während für Pulver niedrigere Sinter- und Tempertemperaturen angewendet werden können. Beispielsweise kann dann das Sintern bei einer Temperatur im Bereich von 500 bis 800 °C erfolgen. Für Formkörper/Festkörper erfolgt das Sintern besonders bevorzugt bei einer Temperatur im Bereich von 1000 bis 1300 °C, insbesondere von 1100 bis 1300 °C. Das Tempern kann dann beispielsweise bei 600 bis 700 °C erfolgen.

Das Sintern wird vorzugsweise für einen Zeitraum von 1 bis 50 Stunden, besonders bevorzugt 2 bis 20 Stunden, insbesondere 5 bis 15 Stunden durchgeführt. Das Tempern wird vorzugsweise für eine Zeit im Bereich von 10 bis 100 Stunden, besonders bevorzugt 10 bis 60 Stunden, insbesondere 30 bis 50 Stunden durchgeführt. Die exakten Zeiträume können dabei je nach Material den praktischen Anforderungen angepasst werden.

Bei Einsatz des Schmelzspinnverfahrens kann der Zeitraum für ein Sintern oder Tempern stark verkürzt werden, beispielsweise auf Zeiträume von 5 Minuten bis 5 Stunden, bevorzugt 10 Minuten bis 1 Stunde. Im Vergleich zu den sonst üblichen Werten von 10 Stunden für das Sintern und 50 Stunden für das Tempern resultiert ein extremer Zeitvorteil.

Durch das Sintern/Tempern kommt es zu einem Anschmelzen der Korngrenzen, so dass sich das Material weiter verdichtet.

Durch das Schmelzen und schnelle Abkühlen in Stufe b) kann damit die Zeitdauer für Stufe c) erheblich vermindert werden. Dies ermöglicht auch eine kontinuierliche Herstellung der thermomagnetischen Materialien.

Erfindungsgemäß besonders bevorzugt ist die Verfahrenssequenz
a) Festphasenumsetzung von chemischen Elementen und/oder Legierungen in einer Stöchiometrie, die dem thermomagnetischen Material entspricht, in einer Kugelmühle,
b) Schmelzspinnen des in Stufe a) erhaltenen Materials,
c) Tempern des Festkörpers aus Stufe b) für einen Zeitraum von 10 Sekunden oder 1 Minute bis 5 Stunden, bevorzugt 30 Minuten bis 2 Stunden, bei einer Temperatur im Bereich von 430 bis 1200 °C, bevorzugt 800 bis 1000 °C.
d) Abschrecken des getemperten Festkörpers aus Stufe c) mit einer Abkühlgeschwindigkeit von 200 bis 1300 K/s.

Alternativ kann in Stufe c) ein Mahlen der erhaltenen Bänder zu einem kleinteiligen Werkstoff, z. B. Pulver, und Verpressen des Werkstoffs in einem Formkörper oder Verarbeitung durch andere Formgebungsverfahren erfolgen.

Das thermomagnetische Material kann in beliebiger geeigneter Form im thermomagnetischen Generator vorliegen. Bevorzugt ist eine Form, die ein einfaches und schnelles Erhitzen und Abkühlen erlaubt. Bevorzugt liegt das thermomagnetische Material in Form von Röhren, Platten, Netzen, Gittern oder Stäben vor. Röhren können beispielsweise in Form von Rohrbündeln angeordnet sein und Platten können in einer Abfolge parallel liegender Platten vorliegen. Gleiches gilt für Netze oder Gitter. Bevorzugt ist das thermomagnetische Material so angeordnet, dass ein guter Wärmeübergang möglich ist bei einem möglichst geringen Druckverlust. Formkörper wie Monolithe oder Wabenkörper können beispielsweise durch ein Heißextrusionsverfahren hergestellt werden. Es können beispielsweise Zelldichten von 400 bis 1600 CPI oder mehr vorliegen. Auch durch Walzverfahren erhältliche dünne Bleche sind erfindungsgemäß einsetzbar. Vorteilhaft sind nicht-poröse Formkörper aus geformtem dünnem Material. Auch Metallspritzgußverfahren (MIM) können erfindungsgemäß durchgeführt werden zur Formgebung.

Die Wärmeübergangsrate limitiert die Zyklusgeschwindigkeit und hat damit einen großen Einfluss auf die Leistungsdichte. Hohe Wärmeübertragungskoeffizienten werden beispielsweise für gewebte Drahtnetze oder Siebe erhalten. Die Optimierung der Geometrie des thermomagnetischen Generators kann wie von L. D. Kirol und J. I. Nills in Proc. Intersociety Energy Conversion Engineering Conference, San Francisco, CA, USA, 1984, Vol. 3,1361 beschrieben erfolgen.

Typischerweise wird das thermomagnetische Material mit einem Fluid als Wärmeübertragungsmedium kontaktiert. Hierbei kann es sich um Gase oder Flüssigkeiten handeln, insbesondere um Luft oder Wasser. Die konkrete Ausgestaltung der dreidimensionalen Struktur ist dabei dem Fachmann bekannt.

Um das thermomagnetische Material ist eine Spule aus einem elektrisch leitfähigen Material angeordnet. In dieser Spule wird durch Veränderung des Magnetfeldes bzw. der Magnetisierung ein Strom induziert, der zur Verrichtung von elektrischer Arbeit verwendet werden kann. Vorzugsweise werden die Spulengeometrie und die Geometrie des thermomagnetischen Materials so gewählt, dass eine möglichst hohe Energieausbeute bei einem möglichst geringen Druckverlust resultiert. Die Spulenwindungsdichte (Windungen/Länge), die Spulenlänge, der Ladungswiderstand und die Temperaturveränderung des thermomagnetischen Materials sind wichtige Einflussgrößen für die Energieausbeute.

Um den magnetokalorischen Effekt in einem weiten Temperaturbereich ausnutzen zu können, ist es bevorzugt, eine Serie von mindestens 5, insbesondere mindestens 10 unterschiedlichen metallbasierten Materialien im thermomagnetischen Generator anzuordnen, deren magnetokalorischer Effekt bei unterschiedlichen Temperaturen auftritt, so dass die Umwandlung der Wärmeenergie in elektrische Energie eine vergrößerte Temperaturspanne ausnutzen kann. Die thermomagnetischen Materialien können dabei gemäß ihrer Curie-Temperatur angeordnet sein und in einer Reihe mechanisch miteinander verbunden sein. Hierdurch ist es möglich, eine breitere Temperaturspanne abzudecken, da der Effekt über die Temperatur integriert wird.

Das thermomagnetische Material befindet sich in einem äußeren Magnetfeld. Dieses Magnetfeld kann durch Permanentmagnete oder Elektromagnete erzeugt werden. Elektromagnete können herkömmliche Elektromagnete oder supraleitende Magnete sein.

Vorzugsweise ist der thermomagnetische Generator so ausgelegt, dass die Wärmeenergie aus der Geothermie oder aus der Abwärme industrieller Prozesse oder aus Solarenergie oder Sonnenkollektoren, z. B. in der Photovoltaik, umgewandelt werden kann. Gerade in Regionen mit geothermischer Aktivität erlaubt der erfindungsgemäße thermomagnetische Generator eine einfache Stromerzeugung unter Ausnutzung der Erdwärme. In industriellen Prozessen fällt häufig Prozesswärme oder Abwärme an, die üblicherweise in die Umgebung abgeleitet und nicht weiter genutzt wird. Auch Abwässer weisen häufig eine höhere Temperatur beim Austritt als beim Eintritt auf. Gleiches gilt für Kühlwasser. Damit erlaubt der thermomagnetische Generator die Gewinnung von elektrischer Energie aus Abwärme, die ansonsten verloren geht. Dadurch, dass der thermomagnetische Generator im Bereich der Raumtemperatur betrieben werden kann, ist es möglich, diese Abwärmen zu nutzen und in elektrische Energie umzuwandeln. Die Energieumwandlung erfolgt dabei vorzugsweise bei Temperaturen im Bereich von 20 bis 150 °C, besonders bevorzugt bei Temperaturen im Bereich von 40 bis 120 °C.

In (konzentrierten) Photovoltaikanlagen werden häufig hohe Temperaturen erreicht, so dass gekühlt werden muss. Diese abzuführende Wärme kann erfindungsgemäß in Strom umgewandelt werden.

Zur Stromerzeugung wird das thermomagnetische Material abwechselnd mit einem warmen Reservoir und einem kalten Reservoir kontaktiert und damit einem Aufwärm- und Abkühlungszyklus unterworfen. Die Zykluszeit wird dabei nach den jeweiligen technischen Voraussetzungen gewählt.

Die nachfolgenden Beispiele beschreiben die Herstellung für die erfindungsgemäße Anwendung geeigneter thermomagnetischer Materialien.

### Beispiele

### Beispiel 1

Evakuierte Quarzampullen, die gepresste Proben von MnFePGe enthielten, wurden für 10 Stunden bei 1100 °C gehalten, um das Pulver zu sintern. Auf dieses Sintern folgte ein Tempern bei 650 °C für 60 Stunden, um eine Homogenisierung herbeizuführen. Anstelle eines langsamen Abkühlens im Ofen auf Raumtemperatur wurden die Proben jedoch sofort in Wasser bei Raumtemperatur gequencht. Das Quenchen in Wasser verursachte einen gewissen Grad von Oxidation an den Probenoberflächen. Die äußere oxidierte Schale wurde durch Ätzen mit verdünnter Säure entfernt. Die XRD-Muster zeigen, dass alle Proben in einer Struktur des Fe₂P-Typs kristallisieren.

Folgende Zusammensetzungen wurden dabei erhalten:
Mn_{1,1}Fe_{0,9}P_{0,81}Ge_{0,19}; M n_{1,1}Fe_{0,9}P_{0,78}Ge_{0,22}, Mn_{1,1}Fe_{0,9}P_{0,75}Ge_{0,25} und Mn_{1,2}Fe_{0,8}P_{0,81}Ge_{0,19}. Die beobachteten Werte für die thermische Hysterese sind für diese Proben in der angegebenen Reihenfolge 7 K, 5 K, 2 K und 3 K. Gegenüber einer langsam abgekühlten Probe war die eine thermische Hysterese von mehr als 10 K aufweist, konnte die thermische Hysterese stark vermindert werden.

Die thermische Hysterese wurde dabei in einem Magnetfeld von 0,5 Tesla bestimmt.

Figur 1 zeigt die isotherme Magnetisierung von Mn_{1,1}Fe_{0,9}B_{0,78}Ge_{0,22} in der Nähe der Curie-Temperatur mit wachsendem Magnetfeld. Ein Feld-induziertes Übergangsverhalten, das zu einer großen MCE führt, wird für Magnetfelder von bis zu 5 Tesla beobachtet.

Die Curie-Temperatur kann durch Variation des Mn/Fe-Verhältnisses und der Ge-Konzentration eingestellt werden, ebenso der Wert für die thermische Hysterese.

Die Änderung der magnetischen Entropie, berechnet aus der Gleichstrommagnetisierung unter Verwendung der Maxwell-Beziehung beträgt für eine maximale Feldänderung von 0 bis 2 Tesla für die ersten drei Proben 14 J/kgK, 20 J/kgK bzw. 12,7 J/kgK.

Die Curie-Temperatur und die thermische Hysterese nehmen mit zunehmendem Mn/Fe-Verhältnis ab. Im Ergebnis zeigen die MnFePGe-Verbindungen relativ große MCE-Werte in niedrigem Feld. Die thermische Hysterese dieser Materialien ist sehr klein.

### Beispiel 2

### Schmelzspinnen von MnFeP(GeSb)

Die polykristallinen MnFeP(Ge,Sb)-Legierungen wurden zunächst in einer Kugelmühle mit hohem Energie-Eintrag und durch Festphasenreaktionsverfahren hergestellt, wie sie in WO 2004/068512 und J. Appl. Phys. 99,08 Q107 (2006) beschrieben sind. Die Materialstücke wurden sodann in ein Quarzrohr mit einer Düse gegeben. Die Kammer wurde auf ein Vakuum von 10⁻² mbar evakuiert und anschließend mit Argongas hoher Reinheit gefüllt. Die Proben wurden durch Hochfrequenz geschmolzen und durch die Düse versprüht aufgrund einer Druckdifferenz zu einer Kammer mit einer rotierenden Kupfertrommel. Die Oberflächengeschwindigkeit des Kupferrades konnte eingestellt werden, und Abkühlgeschwindigkeiten von etwa 10⁵ K/s wurden erreicht. Anschließend wurden die gesponnenen Bänder bei 900 °C für eine Stunde getempert.

Aus der Röntgendiffraktometrie geht hervor, dass alle Proben im hexagonalen Fe₂P-Strukturmuster kristallisieren. Im Unterschied zu nicht nach dem Schmelzspinnverfahren hergestellten Proben, wurde keine kleinere Verunreinigungsphase von MnO beobachtet.

Die erhaltenen Werte für die Curie-Temperatur, die Hysterese und die Entropie wurden für unterschiedliche Umfangsgeschwindigkeiten beim Schmelzspinnen bestimmt. Die Ergebnisse sind in den nachstehenden Tabellen 1 und 2 aufgeführt. Jeweils wurden geringe Hysterese-Temperaturen bestimmt.

**Tabelle 1:**

| **Bänder** | **V (m/s)** | **T_{c} (K)** | **ΔT_{hys} (K)** | **-ΔS(J/kgK)** |
|---|---|---|---|---|
| Mn_{1,2}Fe_{0,8}P_{0,73}Ge_{0,25}Sb_{0,02} | 30 | 269 | 4 | 12,1 |
| Mn_{1,2}Fe_{0,8}P_{0,70}Ge_{0,20}Sb_{0,10} | 30 | 304 | 4,5 | 19,0 |
| | 45 | 314 | 3 | 11,0 |
| MnFeP_{0,70}Ge_{0,20}Sb_{0,10} | 20 | 306 | 8 | 17,2 |
| | 30 | 340 | 3 | 9,5 |
| MnFeP_{0,75}Ge_{0,25} | 20 | 316 | 9 | 13,5 |
| | 40 | 302 | 8 | - |
| Mn_{1,1}Fe_{0,9}P_{0,78}Ge_{0,22} | 20 | 302 | 5 | - |
| | 40 | 299 | 7 | - |
| Mn_{1,1}Fe_{0,9}P_{0,75}Ge_{0,25} | 30 | 283 | 9 | 11,2 |
| Mn_{1,2}Fe_{0,8}P_{0,75}Ge_{0,25} | 30 | 240 | 8 | 14,2 |
| Mn_{1,1}Fe_{0,9}P_{0,73}Ge_{0,27} | 30 | 262 | 5 | 10,1 |

| **Bulk** | | **T_{c} (K)** | **ΔT_{hys} (K)** | **-ΔS(J/kgK)** |
|---|---|---|---|---|
| MnFeP_{0,75}Ge_{0,25} | | 327 | 3 | 11,0 |
| Mn_{1,1}Fe_{0,9}P_{0,81}Ge_{0,19} | | 260 | 7 | 14,0 |
| Mn_{1,1}Fe_{0,9}P_{0,78}Ge_{0,22} | | 296 | 5 | 20,0 |
| Mn_{1,1}Fe_{0,9}P_{0,75}Ge_{0,25} | | 330 | 2 | 13,0 |
| Mn_{1,2}Fe_{0,8}P_{0,81}Ge_{0,19} | | 220 | 3 | 7,7 |
| Mn_{1,2}Fe_{0,8}P_{0,75}Ge_{0,25} | | 305 | 3 | - |
| Mn_{1,2}Fe_{0,8}P_{0,73}Ge_{0,27} | | 313 | 5 | - |
| Mn_{1,3}Fe_{0,7}P_{0,78}Ge_{0,22} | | 203 | 3 | 5,1 |
| Mn_{1,3}Fe_{0,7}P_{0,75}Ge_{0,25} | | 264 | 1 | - |

**Tabelle 2**

| **Bulk** | **T_{c} (K)** | **ΔT_{hys} (K)** | **-ΔS(J/kgK)** |
|---|---|---|---|
| MnFeP_{0,75}Ge_{0,25} | 327 | 3 | 11,0 |
| Mn_{1,16}Fe_{0,84}P_{0,75}Ge_{0,25} | 330 | 5 | 22,5 |
| Mn_{1,18}Fe_{0,82}P_{0,75}Ge_{0,25} | 310 | 3 | 16,1 |
| Mn_{1,20}Fe_{0,80}P_{0,75}Ge_{0,25} | 302 | 1 | 12,0 |
| Mn_{1,22}Fe_{0,78}P_{0,75}Ge_{0,25} | 276 | 4 | 11,7 |
| Mn_{1,26}Fe_{0,74}P_{0,75}Ge_{0,25} | 270 | 1 | 8,5 |
| Mn_{1,1}Fe_{0,9}P_{0,81}Ge_{0,19} | 260 | 6 | 13,8 |
| Mn_{1,1}Fe_{0,9}P_{0,78}Ge_{0,22} | 296 | 4 | 20,0 |
| Mn_{1,1}Fe_{0,9}P_{0,77}Ge_{0,23} | 312 | 2 | 14,6 |
| Mn_{1,1}Fe_{0,9}P_{0,75}Ge_{0,25} | 329 | 2 | 13,0 |

| **Bänder** | | | |
|---|---|---|---|
| Mn_{1,20}Fe_{0,80}P_{0,75}Ge_{0,25} | 288 | 1 | 20,3 |
| Mn_{1,22}Fe_{0,78}P_{0,75}Ge_{0,25} | 274 | 2 | 15,3 |
| Mn_{1,24}Fe_{0,76}P_{0,75}Ge_{0,25} | 254 | 2 | 16,4 |
| Mn_{1,26}Fe_{0,74}P_{0,75}Ge_{0,25} | 250 | 4 | 14,4 |
| Mn_{1,30}Fe_{0,70}P_{0,75}Ge_{0,25} | 230 | 0 | 9,8 |

## Patentansprüche

1. Thermomagnetischer Generator, der Wärmeenergie in elektrische Energie umwandelt ohne zwischenzeitliche Umwandlung in mechanische Arbeit, der bei Temperaturen im Bereich von -20 °C bis 200 °C arbeitet und eine Serie von mindestens drei unterschiedlichen metallbasierten Materialien enthält, deren magnetokalorischer Effekt bei unterschiedlichen Temperaturen auftritt, so dass die Umwandlung der Wärmeenergie in elektrische Energie eine vergrößerte Temperaturspanne ausnutzen kann, ausgewählt aus
(1) Verbindungen der allgemeinen Formel (I)
(A_{y}B_{1-y})_{2+δ}C_{w}DₓE_{z} (I)
mit der Bedeutung
A Mn oder Co,
B Fe, Cr oder Ni,
C, D, E mindestens zwei von C, D, E sind voneinander verschieden, haben eine nicht-verschwindende Konzentration und sind ausgewählt aus P, B, Se, Ge, Ga, Si, Sn, N, As und Sb, wobei mindestens eines von C, D und E Ge oder Si ist,
δ Zahl im Bereich von - 0,1 bis 0,1
w, x, y, z Zahlen im Bereich von 0 bis 1, wobei w + x + z = 1 ist;
(2) auf La und Fe basierenden Verbindungen der allgemeinen Formeln (II) und/oder (III) und/oder (IV)
La(FeₓAl₁₋ₓ)₁₃H_{y} oder La(FeₓSi₁₋ₓ)₁₃H_{y} (II)
mit
x Zahl von 0,7 bis 0,95
y Zahl von 0 bis 3;
La(FeₓAl_{y}Co_{z})₁₃ oder La(FeₓSi_{y}Co_{z})₁₃ (III)
mit
x Zahl von 0,7 bis 0,95
y Zahl von 0,05 bis 1 - x
z Zahl von 0,005 bis 0,5;
LaMnₓFe₂₋ₓGe (IV)
mit
x Zahl von 1,7 bis 1,95 und
(3) Heusler-Legierungen des Typs MnTP mit T Übergangsmetall und P einem p-dotierenden Metall mit einem electron count pro Atom e/a im Bereich von 7 bis 8,5,
(4) auf Gd und Si basierenden Verbindungen der allgemeinen Formel (V)
Gd₅(SiₓGe₁₋ₓ)₄ (V)
mit x Zahl von 0,2 bis 1,
(5) Fe₂P-basierten Verbindungen,
(6) Manganiten des Perovskit-Typs,
(7) Seltenerden-Elemente enthaltenden Verbindungen der allgemeinen Formeln (VI) und (VII)
Tb₅(Si₄₋ₓGeₓ) (VI)
mit x = 0, 1, 2, 3, 4
XTiGe (VII)
mit X = Dy, Ho, Tm,
(8) auf Mn und Sb oder As basierenden Verbindungen der allgemeinen Formeln (VIII) und (IX)
Mn₂₋ₓZₓSb (VIII)
Mn₂ZₓSb₁₋ₓ (IX)
mit
Z Cr, Cu, Zn, Co, V, As, Ge,
x 0,01 bis 0,5,
wobei Sb durch As ersetzt sein kann, sofern Z nicht As ist.

2. Thermomagnetischer Generator nach Anspruch 1, **dadurch gekennzeichnet, dass** das thermomagnetische Material ausgewählt ist aus mindestens quarternären Verbindungen der allgemeinen Formel (I), die neben Mn, Fe, P und gegebenenfalls Sb zusätzlich Ge oder Si oder As oder Fe und Si oder Ge und As oder Si und As, oder Ge, Si und As enthalten.

3. Thermomagnetischer Generator nach Anspruch 1 oder 2, **dadurch gekennzeichnet, dass** er so ausgelegt ist, dass die Wärmeenergie aus der Geothermie oder aus der Abwärme industrieller Prozesse oder aus Solarenergie der Sonnenkollektoren umgewandelt werden kann.

4. Thermomagnetischer Generator nach einem der Ansprüche 1 bis 3, **dadurch gekennzeichnet, dass** die Energieumwandlung bei Temperaturen im Bereich von 20 bis 150 °C erfolgt.

5. Thermomagnetischer Generator nach einem der Ansprüche 1 bis 4, **dadurch gekennzeichnet, dass** das thermomagnetische Material in Form von Röhren, Platten, Netzen, Gittern, Bändern, Drähten oder Stäben vorliegt.

6. Verfahren zur Herstellung eines thermomagnetischen Generators nach einem der Ansprüche 1 bis 4, **dadurch gekennzeichnet, dass** die metallbasierten Materialien hergestellt sind durch
a) Umsetzung von chemischen Elementen und/oder Legierungen in einer Stöchiometrie, die dem thermomagnetischen Material entspricht, in der Fest- und/oder Flüssigphase,
b) gegebenenfalls Überführen des Umsetzungsproduktes aus Stufe a) in einen Festkörper,
c) Sintern und/oder Tempern des Festkörpers aus Stufe a) oder b),
d) Abschrecken des gesinterten und/oder getemperten Festkörpers aus Stufe c) mit einer Abkühlgeschwindigkeit von mindestens 100 K/s.

## Claims

1. A thermomagnetic generator which converts thermal energy to electrical energy without intermediate conversion to mechanical work, which works at temperatures in the range from -20°C to 200°C and comprises a series of at least three different metal-based materials whose magnetocaloric effect occurs at different temperatures, such that the conversion of thermal energy to electrical energy can exploit an enlarged temperature range, selected from
(1) compounds of the general formula (I)
(A_{y}B_{1-y})_{2+δ}C_{w}DₓE_{z} (I)
where
A is Mn or Co,
B is Fe, Cr or Ni,
C, D and E at least two of C, D and E are different, have a non-vanishing concentration and are selected from P, B, Se, Ge, Ga, Si, Sn, N, As and Sb, where at least one of C, D and E is Ge or Si,
δ is a number in the range from -0.1 to 0.1,
w, x, y, z are numbers in the range from 0 to 1, where w + x + z = 1;
(2) La- and Fe-based compounds of the general formulae (II) and/or (III) and/or (IV)
La(FeₓAl₁₋ₓ)₁₃H_{y} or La(FeₓSi₁₋ₓ)₁₃H_{y} (II)
where
x is a number from 0.7 to 0.95,
y is a number from 0 to 3;
La (FeₓAl_{y}Co_{z})₁₃ or La(FeₓSi_{y}Co_{z})₁₃ (III)
where
x is a number from 0.7 to 0.95,
y is a number from 0.05 to 1 - x,
z is a number from 0.005 to 0.5; LaMnₓFe₂₋ₓGe (IV)
where
x is a number from 1.7 to 1.95 and
(3) Heusler alloys of the MnTP type where T is a transition metal and P is a p-doping metal having an electron count per atom e/a in the range from 7 to 8.5,
(4) Gd- and Si-based compounds of the general formula (V)
Gd₅(SiₓGe₁₋ₓ)₄ (V)
where x is a number from 0.2 to 1,
(5) Fe₂P-based compounds,
(6) manganites of the perovskite type,
(7) compounds which comprise rare earth elements and are of the general formulae (VI) and (VII)
Tb₅(Si₄₋ₓGeₓ) (VI)
where x = 0, 1, 2, 3, 4,
XTiGe (VII)
where X = Dy, Ho, Tm,
(8) Mn- and Sb- or As-based compounds of the general formulae (VIII) and (IX)
Mn₂₋ₓZₓSb (VIII)
Mn₂ZₓSb₁₋ₓ (IX)
where
Z is Cr, Cu, Zn, Co, V, As, Ge,
x is from 0.01 to 0.5,
where Sb may be replaced by As when Z is not As.

2. The thermomagnetic generator according to claim 1, wherein the thermomagnetic material is selected from at least quaternary compounds of the general formula (I) which, as well as Mn, Fe, P and optionally Sb, additionally comprise Ge or Si or As or Fe and Si or Ge and As or Si and As, or Ge, Si and As.

3. The thermomagnetic generator according to claim 1 or 2, which is designed such that the thermal energy from geothermal sources or from the waste heat of industrial processes or from solar energy or solar collectors can be converted.

4. The thermomagnetic generator according to any one of claims 1 to 3, wherein the energy conversion is effected at temperatures in the range from 20 to 150°C.

5. The thermomagnetic generator according to any one of claims 1 to 4, wherein the thermomagnetic material is present in the form of tubes, plates, meshes, grids, ribbons, wires or rods.

6. A process for producing a thermomagnetic generator according to any one of claims 1 to 4, wherein the metal-based materials are produced by
a) reacting chemical elements and/or alloys in a stoichiometry which corresponds to the thermomagnetic material in the solid and/or liquid phase,
b) optionally converting the reaction product from stage a) to a solid,
c) sintering and/or heat treating the solid from stage a) or b),
d) quenching the sintered and/or heat-treated solid from stage c) at a cooling rate of at least 100 K/s.

## Revendications

1. Générateur thermomagnétique, qui transforme de l'énergie thermique en énergie électrique sans conversion intermédiaire en travail mécanique, qui fonctionne à des températures dans la plage de -20 °C à 200 °C et contient une série d'au moins trois différents matériaux à base de métaux, dont l'effet magnétocalorique se manifeste à différentes températures, de sorte que la transformation de l'énergie thermique en énergie électrique peut utiliser une plage élargie de température, choisis parmi
(1) des composés de formule générale (I)
(A_{y}B_{1-y})_{2+δ}C_{w}DₓE_{z} (I)
dans laquelle
A représente Mn ou Co,
B représente Fe, Cr ou Ni,
C, D, E au moins deux de C, D, E sont différents l'un de l'autre, ont une concentration non nulle et sont choisis parmi P, B, Se, Ge, Ga, Si, Sn, N, As et Sb, au moins un de C, D et E étant Ge ou Si,
δ est un nombre dans la plage de -0,1 à 0,1 ;
w, x, y, z sont des nombres dans la plage de 0 à 1, la somme w + x + z étant égale à 1 ;
(2) des composés à base de La et Fe, de formules générales (II) et/ou (III) et/ou (IV)
La(FeₓAl₁₋ₓ)₁₃H_{y} ou La(FeₓSi₁₋ₓ)₁₃H_{y} (II)
où
x est un nombre valant de 0,7 à 0,95
y est un nombre valant de 0 à 3 ;
La(FeₓAl_{y}Co_{z})₁₃ ou La(FeₓSi_{y}Co_{z})₁₃ (III)
où
x est un nombre valant de 0,7 à 0,95
y est un nombre valant de 0,05 à 1-x
z est un nombre valant de 0,005 à 0,5
LaMnₓFe₂₋ₓGe (IV)
où
x est un nombre valant de 1,7 à 1,95 et
(3) des alliages de Heusler du type MnTP où T représente un métal de transition et P un métal p-dopant ayant un nombre d'électrons par atome e/a dans la plage de 7 à 8,5,
(4) des composés à base de Gd et Si, de formule générale (V)
Gd₅ (SiₓGe₁₋ₓ)₄ (V)
où x est un nombre valant de 0,2 à 1,
(5) des composés à base de Fe₂P,
(6) des manganites du type pérovskite,
(7) des composés contenant des éléments de terres rares, de formules générales (VI) et (VII)
Tb₅(Si₄₋ₓGeₓ) (VI)
où x = 0, 1, 2, 3, 4
XTiGe (VII)
où X = Dy, Ho, Tm,
(8) des composés à base de Mn et Sb ou As, de formules générales (VIII) et (IX)
Mn₂₋ₓZₓSb (VIII)
Mn₂ZₓSb₁₋ₓ (IX)
où
Z représente Cr, Cu, Zn, Co, V, As, Ge,
x vaut de 0,01 à 0,5,
Sb pouvant être remplacé par As lorsque Z n'est pas As.

2. Générateur thermomagnétique selon la revendication 1, **caractérisé en ce que** le matériau thermomagnétique est choisi parmi des composés au moins quaternaires de formule générale (I) qui en plus de Mn, Fe, P et éventuellement Sb contiennent en outre Ge ou Si ou As ou Fe et Si ou Ge et As ou Si et As, ou Ge, Si et As.

3. Générateur thermomagnétique selon la revendication 1 ou 2, **caractérisé en ce qu'**il est conçu de telle sorte que l'énergie thermique provenant de la géothermie ou de la chaleur dissipée de processus industriels ou de l'énergie solaire des capteurs solaires peut être transformée.

4. Générateur thermomagnétique selon l'une quelconque des revendications 1 à 3, **caractérisé en ce que** la transformation d'énergie s'effectue à des températures dans la plage de 20 à 150 °C.

5. Générateur thermomagnétique selon l'une quelconque des revendications 1 à 4, **caractérisé en ce que** le matériau thermomagnétique se trouve sous forme de tubes, plaques, treillis, grilles, rubans, fils métalliques ou barres.

6. Procédé pour la fabrication d'un générateur thermomagnétique selon l'une quelconque des revendications 1 à 4, **caractérisé en ce que** les matériaux à base de métaux sont produits par
a) mise en réaction d'éléments chimiques et/ou d'alliages en une stoechiométrie qui correspond au matériau thermomagnétique, dans la phase solide et/ou la phase liquide,
b) éventuellement transformation du produit de réaction provenant de l'étape a) en un corps solide,
c) frittage et/ou traitement thermique du corps solide provenant de l'étape a) ou b),
d) brusque refroidissement à une vitesse de refroidissement d'au moins 100 K/s du corps solide fritté et/ou traité thermiquement, provenant de l'étape c).
